# EUROPÄISCHE PATENTANMELDUNG

(11) **EP 0 559 607 A2**
(43) Veröffentlichungstag der Anmeldung: **08.09.1993**
(21) Anmeldenummer: 93810103.7
(22) Anmeldetag: 19.02.1993
(51) Int. Cl.: C08L 63/06, C08J 5/24, C08G 59/06, C08G 59/38

(54) **Epoxidharze auf Basis von Triglycidylisocyanurat**

(30) Priorität: 28.02.1992 CH 620/92
(71) Anmelder: CIBA-GEIGY AG, CH-4002 Basel (CH)
(72) Erfinder: Knobloch, Wilhelm, Dr., W-7881 Schwörstadt (DE); Magnani, Piergiorgio, Dr., CH-4226 Breitenbach (CH); Haug, Theobald, Dr., CH-4402 Frenkendorf (CH)

(57) **Zusammenfassung**

Zusammensetzungen enthaltend
(a) eine oder mehrere Polyglycidylverbindungen der Formeln (I), (II) oder (III) 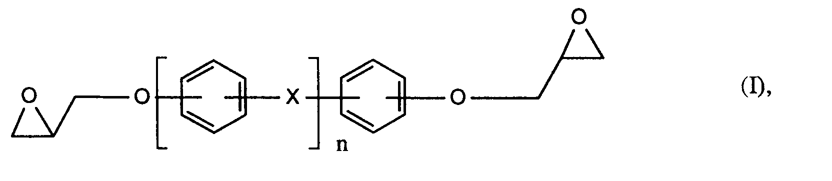 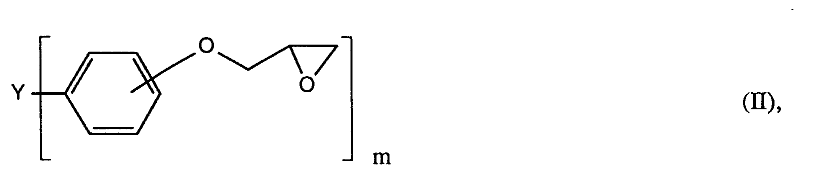 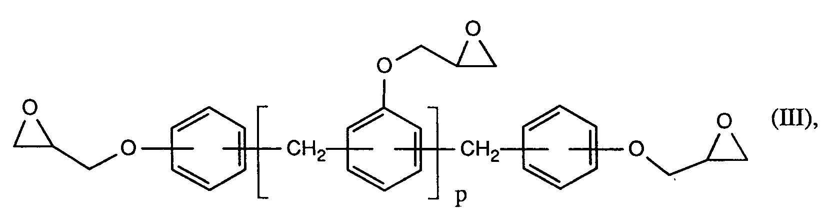 worin X für eine direkte Bindung, -CH₂-, -C(CH₃)₂-, -O-, -CO- oder -SO₂- steht, Y den m-wertigen Rest eines gesättigten C₁-C₃-Kohlenwasserstoffs darstellt, n und p unabhängig voneinander eine ganze Zahl zwischen 1 und 6 bedeuten, m eine ganze Zahl zwischen 2 und 6 ist und worin die aromatischen Ringe in den Formeln (I), (II) und (III) unsubstituiert oder durch eine oder mehrere C₁-C₆-Alkylgruppen oder Halogenatome substituiert sind,
(b) eine aromatische Di- oder Trihydroxyverbindung und
(c) 1-30 Gew.%, bezogen auf die Gesamtzusammensetzung, Triglycidylisocyanurat, eignen sich zur Herstellung von Prepregs und Laminaten mit hoher Glasübergangstemperatur und guter Kupferhaftung.

## Beschreibung

Die vorliegende Erfindung betrifft härtbare Zusammensetzungen enthaltend Triglycidylisocyanurat, bestimmte Polyglycidylverbindungen und eine aromatische Di- oder Trihydroxyverbindung sowie deren Verwendung zur Herstellung von Prepregs und Laminaten.

Bei der Herstellung von Leiterplatten für gedruckte Schaltungen werden üblicherweise faserverstärkte Laminierharze verwendet, die unter Druck bei erhöhter Temperatur zu Laminaten verpresst werden.
Bei der industriellen Anwendung stellt die oftmals schlechte "Bohrbarkeit" der Laminate ein Problem dar, d.h. beim Bohren der Leiterplatten wird das Metall des Bohrers vom Harz angegriffen, und der Bohrer muss nach relativ kurver Zeit ausgetauscht werden.

Die JP-A 89-29415 beschreibt ein mit einem Laminierharz auf Basis von Epoxidharzen und Triglycidylisocyanurat imprägniertes Glasgewebe, das Laminate mit guter Hitzebeständigkeit liefert.

Die JP-A 89-225641 offenbart ein Verfahren zur Herstellung von hitzebeständigen Epoxidharz-Laminaten, worin ein Epoxidharz auf Basis von Bisphenol A oder ein Epoxy-Novolak mit dem Reaktionsprodukt von Triglycidylisocyanurat und Bisphenol A oder Tetrabrombisphenol A modifiziert und anschliessend in der üblichen Weise zu Prepregs und Laminaten weiterverarbeitet wird.

Die aus diesen Laminierharzen hergestellten Laminate weisen jedoch für gewisse Anwendungen eine zu niedrige Glasübergangstemperatur und eine geringe Kupferhaftung auf.

Es wurde nun gefunden, dass Zusammensetzungen enthaltend Triglycidylisocyanurat, bestimmte Polyglycidylverbindungen und mindestens eine aromatische Di- oder Trihydroxyverbindung zur Herstellung von Laminaten geeignet sind, die die oben erwähnten Nachteile nicht aufweisen.

Gegenstand der vorliegenden Erfindung ist eine Zusammensetzung enthaltend
(a) eine oder mehrere Polyglycidylverbindungen der Formeln (I), (II) oder (III) 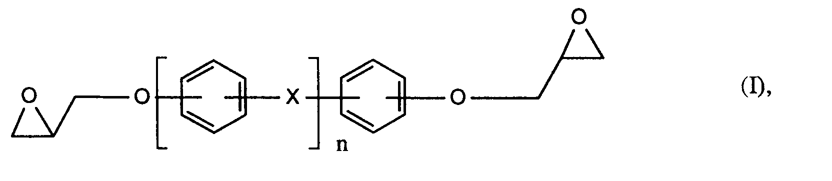 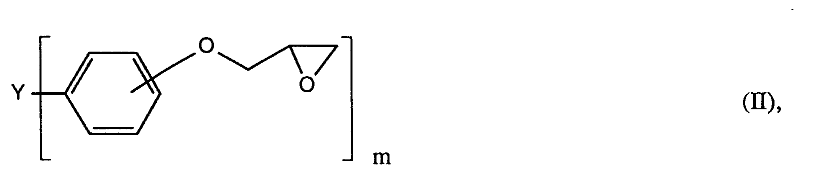 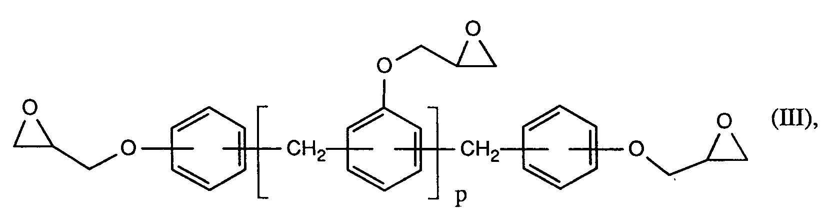 worin X für eine direkte Bindung, -CH₂-, -C(CH₃)₂-, -O-, -CO- oder -SO₂- steht, Y den m-wertigen Rest eines gesättigten C₁-C₃-Kohlenwasserstoffs darstellt, n und p unabhängig voneinander eine ganze Zahl zwischen 1 und 6 bedeuten, m eine ganze Zahl zwischen 2 und 6 ist und worin in den Formeln (I), (II) und (III) die aromatischen Ringe unsubstituiert oder durch eine oder mehrere C₁-C₆-Alkylgruppen oder Halogenatome substituiert sind,
(b) mindestens eine aromatische Di- oder Trihydroxyverbindung und
(c) 1-30 Gew.%, bezogen auf die Gesamtzusammensetzung, Triglycidylisocyanurat.

Die Verbindungen der Formel (I) sind kommerziell erhältlich oder können in bekannter Weise aus den entsprechenden aromatischen Dihydroxyverbindungen und Epichlorhydrin hergestellt werden.
Geeignete Diglycidylverbindungen sind beispielsweise Diglycidylether von gegebenenfalls substituierten Bisphenolen, wie 4,4'-Dihydroxybiphenyl, 4,4'-Dihydroxydiphenylether, 4,4'-Dihydroxybenzophenon, Bisphenol A, Bisphenol F oder Bisphenol S. Für flammgehemmte Harze eignen sich insbesondere Glycidylether von halogenierten Bisphenolen, wie zum Beispiel Tetrabrombisphenol A.

Die Verbindungen der Formel (II) sind ebenfalls bekannt und leiten sich ab von mehrkernigen Phenolen, wie beispielsweise 1,1,2,2-Tetrakis(4-hydroxyphenyl)ethan oder 1,1,3,3-Tetrakis(4-hydroxyphenyl)propan.

Geeignete Verbindungen der Formel (III) sind z.B. glycidylierte Novolake, die durch Kondensation von Aldehyden, wie Formaldehyd, Acetaldehyd oder Chloral, mit gegebenenfalls substituierten Phenolen, wie Phenol, 4-Chlorphenol, 2-Methylphenol oder 4-tert.-Butylphenol, und anschliessende Umsetzung mit Epichlorhydrin hergestellt werden können.
Beispiele dafür sind Epoxy-Phenolnovolake und Epoxy-Kresolnovolake.

Vorzugsweise werden als Komponente (a) Verbindungen der Formel (I) eingesetzt, worin X für -C(CH₃)₂- und n für 2 steht.

Besonders bevorzugt als Komponente (a) ist Bisphenol A-diglycidylether.

Bevorzugt sind auch Zusammensetzungen enthaltend als Komponente (a) 1,1,2,2-Tetrakis(p-glycidyloxyphenyl)ethan gemäss Formel (II) oder einen Epoxy-Kresolnovolak gemäss Formel (III).

Als Komponente (b) können in den erfindungsgemässen Zusammensetzungen grundsätzlich alle in der Methodik der Vorverlängerung bekannten aromatischen Di- oder Trihydroxyverbindungen eingesetzt werden.
Als Beispiele seien genannt: einkernige Diphenole, wie Resorcin oder Hydrochinon, Naphthaline mit zwei Hydroxylgruppen, wie 1,4-Dihydroxynaphthalin, Biphenyle und andere zweikernige aromatische Verbindungen, die eine Methylen-, Isopropyliden-, -O-, -S-, -SO-, -CO- oder -SO₂-Brücke aufweisen und zwei Hydroxylgruppen an den aromatischen Kernen gebunden enthalten, wie insbesondere Bisphenol A, Bisphenol F oder Bisphenol S, wobei die Benzolkerne auch Halogenatome aufweisen können, wie Tetrabrombisphenol A.

Vorzugsweise werden als Komponente (b) Verbindungen der Formel (IV) eingesetzt 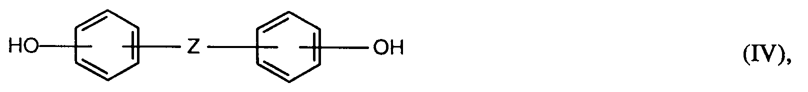
worin Z für eine direkte Bindung, -CH₂-, -C(CH₃)₂-, -O-, -CO- oder -SO₂- steht und worin die aromatischen Ringe unsubstituiert oder durch eine oder mehrere C₁-C₆-Alkylgruppen oder Halogenatome substituiert sind.

In den Verbindungen der Formel (IV) steht Z bevorzugt für -C(CH₃)₂-.

Besonders bevorzugt als Komponente (b) ist Tetrabrombisphenol A.

Vorzugsweise enthalten die erfindungsgemässen Zusammensetzungen 15-25 Gew.-% Triglycidylisocyanurat als Komponente (c).

Die Menge der Komponente (a) kann in weiten Bereichen variieren und beträgt zweckmässigerweise 30-90 Gew.-%, bezogen auf die Gesamtzusammensetzung.

Vorzugsweise enthalten die erfindungsgemässen Zusammensetzungen 40-80 Gew., insbesondere 45-65 Gew.-%, der Komponente (a), bezogen auf die Gesamtzusammensetzung.

Die Menge der in den erfindungsgemässen Zusammensetzungen enthaltenen Komponente (b) kann in weiten Bereichen variieren und hängt vor allem von den gewünschten Eigenschaften des vorverlängerten Harzes ab. Je grösser die Menge der eingesetzten Di- oder Trihydroxyverbindung ist, desto höher ist im allgemeinen das Molekulargewicht und der Schmelzpunkt des Endprodukts.

Vorzugsweise wird die Komponente (b) in einer solchen Menge eingesetzt, dass auf ein Epoxidäquivalent der Komponenten (a)+(c) 0,6-1,2 OH-Gruppenäquivalente entfallen.

Besonders bevorzugt werden pro Epoxidäquivalent der Komponenten (a)+(c) 0,8-1,1, insbesondere 0,9-1,0 OH-Gruppenäquivalente eingesetzt.

Falls zweckmässig, können die erfindungsgemässen Zusammensetzungen neben den Komponenten (a)-(c) zusätzlich einen Vorverlängerungskatalysator (d) enthalten.

Als Komponente (d) können im Prinzip alle dem Fachmann als Vorverlängerungskatalysatoren (AVA-Katalysatoren) für Epoxidharze bekannten Verbindungen eingesetzt werden.

Vorzugsweise werden sekundäre oder tertiäre Amine oder quartäre Ammoniumsalze verwendet.

Beispiele dafür sind aliphatische, cycloaliphatische oder aromatische sekundäre und tertiäre Amine, wie Di-n-butylamin, Triethylamin, Tri-n-butylamin, N,N-Dimethylcyclohexylamin und N,N-Dimethylanilin, heterozyklische Amine, wie Piperidin, N-Methylpiperidin, N-Methylmorpholin, N-Methylpyrrolidin, 2-Phenylimidazol und 2-Ethylimidazol.

Geeignete quartäre Ammoniumsalze sind z.B. die in dem US-Patent 4,465,722 erwähnten Tetraalkylammoniumhydroxide und -halogenide sowie die in den US-Patenten 4,885,354, 4,973,648 und 5,006,626 beschriebenen Piperidinium-, Morpholinium- und Pyrrolidiniumsalze, wie beispielsweise:
Tetramethylammoniumchlorid, Tetrabutylammoniumbromid, N,N-Dimethylpyrrolidiniumchlorid, N-Ethyl-N-methylpyrrolidiniumiodid, N-Butyl-N-methylpyrrolidiniumbromid, N-Benzyl-N-methylpyrrolidiniumchlorid, N-Butyl-N-methylmorpholiniumbromid, N-Butyl-N-methymorpholiniumiodid, N-Ethyl-N-hydroxyethylmorpholiniumiodid, N-Allyl-N-methylmorpholiniumbromid, N-MethylN-benzylpiperidiniumchlorid, N-Methyl-N-benzylpiperidiniumbromid, N,N-Dimethylpiperidiniumiodid, N-Methyl-N-ethylpiperidiniumacetat oder N-MethylN-ethylpiperidiniumiodid.

Besonders bevorzugt als Komponente (d) ist 2-Phenylimidazol.

Die Komponente (d) wird in katalytisch wirksamen Mengen eingesetzt, z.B. in einer Menge von etwa 10-6000 ppm, vorzugsweise 20-4000 ppm und besonders bevorzugt 50-1500 ppm, bezogen auf das Gewicht des Basisharzes (Komponenten a+c).

Die erfindungsgemässen Zusammensetzungen können ohne Verwendung eines Lösungsmittels durch Erhitzen auf 100-200 °C in feste vorverlängerte Epoxidharze überführt werden, die eine ausreichende Lagerstabilität aufweisen und vorzugsweise als Laminierharze verwendet werden können.

Gegenstand der Erfindung ist somit auch ein festes vorverlängertes Epoxidharz erhältlich durch Erhitzen einer Zusammensetzung enthaltend die Komponenten (a)-(c) auf 100-200 °C, bis der Epoxidgehalt des Harzes 2,5-4,0 val/kg beträgt.

Ein weiterer Erfindungsgegenstand ist die Verwendung der so erhaltenen vorverlängerten Epoxidharze zur Herstellung von Prepregs und Laminaten.

Zur Herstellung von Prepregs wird ein Fasergewebe mit einer Lösung enthaltend ein erfindungsgemässes vorverlängertes Epoxidharz und einen latenten Härter imprägniert und kurzzeitig (ca. 2-10 min) auf Temperaturen bis etwa 200 °C erhitzt. Bei diesem Prozess wird das Lösungsmittel entfernt, und das Matrixharz wird relativ rasch in den noch schmelzbaren bzw. härtbaren B-Zustand überführt.

Dabei können die üblichen bei der Faserverstärkung von Werkstoffen verwendeten Fasern eingesetzt werden. Diese können organische oder anorganische Fasern, Naturfasern oder Synthesefasern sein und in Form von Geweben oder Gelegen, Vliesen oder Matten sowie in Form von Fasersträngen (Rovings), als Stapelfasern oder Endlosfasern vorliegen. Beispielsweise verwendet man Glas-, Asbest-, Bor-, Kohlenstoff- oder Metallfasern sowie Aramidfasern, hochfeste Polyesterfasern oder Naturfasern aus Baumwolle oder Zellwolle. Solche Fasern und Gewebe daraus sind im Handel erhältlich.

Das Beschichten dieser Fasern bzw. Gewebe mit dem Matrixharz kann nach den üblichen Imprägniermethoden, durch Bestreichen, Besprühen oder Eintauchen, mittels Strangziehtechnik oder bei Endlosfasern nach dem Präzisionsfaserwicklungsverfahren (filamentwinding) erfolgen.

Als latenter Härter kann im Prinzip jede für diesen Zweck bekannte Verbindung eingesetzt werden, d.h. jede Verbindung, die bei Raumtemperatur gegenüber dem Epoxidharz inert ist, die aber bei erhöhter Temperatur (ab ca. 80 °C) schnell unter Vernetzung des Harzes reagiert.

Beispiele geeigneter latenter Härter sind Dicyandiamid, Cyanoguanidine, wie z.B. die in den US 4,859,761 oder EP-A 306,451 beschriebenen Verbindungen, aromatische Amine, wie z.B. 4,4'-Methylen-bis-(2,6-diethylanilin), oder Guanidine, wie z.B. 1-o-Tolylbiguanid, oder modifizierte Polyamine, wie z.B. Ancamine® 2014 S (Anchor Chemical UK Limited, Manchester).

Bevorzugte latente Härter sind 4,4'-Methylen-bis-(2,6-diethylanilin) und insbesondere Dicyandiamid.

Falls zweckmässig, können die erfindungsgemässen Stoffgemische auch Beschleuniger für die Vernetzungsreaktion mit dem latenten Härter enthalten. Geeignete Beschleuniger sind z.B. Harnstoffderivate, wie N,N-Dimethyl-N'-(3-chlor-4-methylphenyl)harnstoff (Chlortoluron), N,N-Dimethyl-N'-(4-chlorphenyl)harnstoff (Monuron) oder N,N-Dimethyl-N'-(3,4-dichlorphenyl)harnstoff (Diuron), 2,4Bis(N',N'-dimethylureido)toluol oder 1,4-Bis(N',N'-dimethylureido)benzol. Die Verwendung dieser Verbindungen ist beispielsweise in der US 4,283,520 beschrieben. Als Beschleuniger geeignet sind z.B. auch die in der GB 1,192,790 beschriebenen Harnstoffderivate.

Besonders geeignete Beschleuniger sind Imidazole, wie z.B. Imidazol, 2-Ethyl-, 2-Phenyl-, 2-Methyl- und 1-Methylimidazol, ferner 1-Cyanoethyl-2-ethyl-4-methylimidazol oder 2-Ethyl-4-methylimidazol.

Weitere geeignete Beschleuniger sind tertiäre Amine, deren Salze oder quaternäre Ammoniumverbindungen, wie Benzyldimethylamin, 2,4,6-Tris(dimethylaminomethyl)phenol, 4-Aminopyridin, Tripentylammoniumphenolat, Tetramethylammoniumchlorid oder Benzyltributylammoniumbromid oder -chlorid; oder Alkalimetallalkoholate, wie Na-Alkoholate von 2,4-Dihydroxy-3-hydroxymethylpentan.

Besonders bevorzugt ist 2-Methylimidazol.

Gewünschtenfalls kann man den härtbaren Gemischen zur Herabsetzung der Viskosität reaktive Verdünner, wie z.B. Butandioldiglycidylether, Monoglycidylether isomerer höherer Alkohole, wie z.B. Grilonit RV 1814® der Fa. Ems-Chemie oder Butylglycidylether, 2,2,4-Trimethylpentylglycidylether, Phenylglycidylether, Kresylglycidylether oder Glycidylester zusetzen.

Die erfindungsgemässen Stoffgemische können auch Haftvermittler enthalten. Im Prinzip kann jeder bekannte Haftvermittler verwendet werden. Als besonders geeignete Haftvermittler haben sich Silane, wie z.B. γ-Glycidyloxypropyltrimethoxysilan (Silan A-187 der Fa. Union Carbide) oder γ-Mercaptopropyltrimethoxysilan (Silan A-189 der Fa. Union Carbide) oder Titanverbindungen, wie Tetraisopropyl-bis(dioctylphosphonato)-titanat (KR 41B der Fa. Kenrich Petrochemicals, Inc. USA), erwiesen.

Als weitere übliche Zusätze können die erfindungsgemässen Gemische ferner Streck-, Füll- und Verstärkungsmittel, wie beispielsweise Steinkohlenteer, Bitumen, mineralische Silikate, Glimmer, Quarzmehl, Aluminiumoxidhydrat, Bentonite, Wollastonit, Kaolin, Kieselsäureaerogel oder Metallpulver, z.B. Aluminiumpulver oder Eisenpulver, ferner Pigmente und Farbstoffe, wie Russ, Oxidfarben und Titandioxid, Flammschutzmittel, Thixotropiemittel, Verlaufmittel ("flow control agents"), wie Silicone, Wachse und Stearate, die zum Teil auch als Formtrennmittel Anwendung finden, Antioxidantien und Lichtschutzmittel enthalten.

Die erfindungsgemässen Prepregs können in bekannter Weise durch Erhitzen auf ca. 100-200 °C vollständig ausgehärtet werden.

In einer bevorzugten Ausführungsform werden dabei mehrere Lagen solcher Prepregs unter Druck zu Laminaten verpresst.

Die so erhaltenen Laminate zeichnen sich durch hohe Glasumwandlungstemperaturen und gute Kupferhaftungen aus und finden insbesondere Anwendung bei der Herstellung von Leiterplatten für gedruckte Schaltungen.

Auch zu erwähnen ist die gute "Bohrbarkeit" der Laminate, d.h. bei der industriellen Anwendung tritt bei den verwendeten Bohrern im Vergleich zu anderen Hoch-T_{g}-Laminaten nur ein geringer Verschleiss auf.

Bei der Anwendung von Laminaten in der Elektro-Industrie wird häufig eine gute Flammfestigkeit gefordert. Dies wird in der Regel durch Verwendung von halogenierten, insbesondere bromierten Harzen sichergestellt.
Überraschenderweise ist bei den erfindungsgemässen Zusammensetzungen ein geringerer Halogengehalt zur Erreichung der Flammhemmungsstufe V-0 nach UL 94 erforderlich als bei vergleichbaren bekannten Harzsystemen.

### Beispiel 1:

Ein Gemisch aus 467 g Bisphenol A-diglycidylether (Epoxidgehalt: 5,26-5,38 val/kg), 333 g Tetrabrombisphenol A, 200 g Triglycidylisocyanurat und 0,05 g 2-Phenylimidazol wird auf 160 °C erhitzt und ca. 3 h bei dieser Temperatur gehalten. Nach Abkühlen auf ca. 150 °C werden 125 g Methylethylketon zugegeben.
500 g dieser Harzlösung werden mit 140 g einer Lösung von Dicyandiamid in Ethylenglykolmonomethylether (10 Gew.-%) und 0,8 g einer Lösung von 2-Methylimidazol in 3-Methoxypropanol (10 Gew.-%) vermischt. Zur Einstellung einer geeigneten Viskosität werden 40 g Ethylenglykolmonomethylether als Verdünnungsmittel zugegeben.
Mit dieser Lösung wird ein Glasgewebe (200 g/m²) imprägniert und 3 min bei 160 °C getrocknet.
Acht Lagen des so erhaltenen Prepregs werden während 60 min bei 170 °C unter einem Druck von 2-4 MPa ausgehärtet.
Das resultierende Laminat hat eine Glasumwandlungstemperatur von 173 °C. Die Kupferhaftung beträgt 16,0 N/cm bei Raumtemperatur und 0,9 N/cm bei 260 °C.

### Beispiel 2:

Ein Gemisch aus 602 g Bisphenol A-diglycidylether (Epoxidgehalt: 5,26-5,38 val/kg), 100 g Tetrabrombisphenol A, 98 g Bisphenol A, 200 g Triglycidylisocyanurat und 0,05 g 2-Phenylimidazol wird auf 160 °C erhitzt und ca. 3 h bei dieser Temperatur gehalten. Nach Abkühlen auf ca. 150 °C werden 125 g Methylethylketon zugegeben.
509 g dieser Harzlösung werden mit 168 g einer Lösung von Dicyandiamid in Ethylenglykolmonomethylether (10 Gew.-%) und 0,8 g einer Lösung von 2-Methylimidazol in 3-Methoxypropanol (10 Gew.-%) vermischt. Zur Einstellung einer geeigneten Viskosität werden 40 g Ethylenglykolmonomethylether als Verdünnungsmittel zugegeben.
Aus dieser Lösung und Glasgewebe (200 g/m²) werden wie in Beispiel 1 Prepregs hergestellt (Trocknung: 3 min 40 s bei 160 °C), die anschliessend zu einem Laminat verpresst werden. Das Laminat weist eine Glasumwandlungstemperatur von 170 °C auf.

### Beispiel 3:

Ein Gemisch aus 417 g Bisphenol A-diglycidylether (Epoxidgehalt: 5,26-5,38 val/kg), 50 g 1,1,2,2-Tetrakis(p-glycidyloxyphenyl)ethan, 333 g Tetrabrombisphenol A, 200 g Triglycidylisocyanurat und 0,05 g 2-Phenylimidazol wird auf 160 °C erhitzt und ca. 3 h bei dieser Temperatur gehalten. Nach Abkühlen auf ca. 150 °C werden 125 g Methylethylketon zugegeben.
500 g dieser Harzlösung werden mit 148 g einer Lösung von Dicyandiamid in Ethylenglykolmonomethylether (10 Gew.-%) und 0,8 g einer Lösung von 2-Methylimidazol in 3-Methoxypropanol (10 Gew.-%) vermischt. Zur Einstellung einer geeigneten Viskosität werden 40 g Ethylenglykolmonomethylether als Verdünnungsmittel zugegeben.
Aus dieser Lösung und Glasgewebe (200 g/m²) werden wie in Beispiel 1 Prepregs hergestellt (Trocknung: 3 min 40 s bei 160 °C), die anschliessend zu einem Laminat verpresst werden (60 min bei 180 °C). Das Laminat weist eine Glasumwandlungstemperatur von 183 °C auf.

### Beispiel 4:

Ein Gemisch aus 357 g Bisphenol A-diglycidylether (Epoxidgehalt: 5,26-5,38 val/kg), 80 g Epoxy-Kresolnovolak (Epoxidgehalt: 4,4 val/kg), 333 g Tetrabrombisphenol A, 230 g Triglycidylisocyanurat und 0,05 g 2-Phenylimidazol wird auf 160 °C erhitzt und ca. 2 h bei dieser Temperatur gehalten. Nach Abkühlen auf ca. 150 °C werden 125 g Methylethylketon zugegeben.
Die so erhaltene Harzlösung wird wie in Beispiel 1 zu Prepregs verarbeitet (Trocknung: 2 min 45 s bei 160 °C), die anschliessend zu einem Laminat verpresst werden (60 min bei 180 °C).
Das Laminat weist eine Glasumwandlungstemperatur von 184 °C auf.

### Beispiel 5:

Ein Gemisch aus 520 g Bisphenol A-diglycidylether (Epoxidgehalt: 5,26-5,38 val/kg), 30 g Tetrabrombisphenol A-diglycidylether, 260 g Tetrabrombisphenol A, 200 g Triglycidylisocyanurat und 0,05 g 2-Phenylimidazol wird auf 160 °C erhitzt und ca. 3 h bei dieser Temperatur gehalten. Nach Abkühlen auf ca. 150 °C werden 125 g Methylethylketon zugegeben.
500 g dieser Harzlösung werden mit 160 g einer Lösung von Dicyandiamid in Ethylenglykolmonomethylether (10 Gew.-%) und 0,8 g einer Lösung von 2-Methylimidazol in 3-Methoxypropanol (10 Gew.-%) vermischt. Zur Einstellung einer geeigneten Viskosität werden 40 g Ethylenglykolmonomethylether als Verdünnungsmittel zugegeben.
Aus dieser Lösung und Glasgewebe (200 g/m²) werden wie in Beispiel 1 Prepregs hergestellt (Trocknung: 3 min 10 s bei 160 °C), die anschliessend zu einem Laminat verpresst werden (60 min bei 180 °C). Das Laminat weist eine Glasumwandlungstemperatur von 181 °C auf.
Brennbarkeit nach U 94: V-0; totale Brennzeit: 22 s

### Beispiel 6:

Ein Gemisch aus 399 g Bisphenol A-diglycidylether (Epoxidgehalt: 5,26-5,38 val/kg), 300 g Tetrabrombisphenol A, 75 g Triglycidylisocyanurat und 0,7 g 2-Phenylimidazol wird auf 160-170 °C erhitzt und ca. 75 min bei dieser Temperatur gehalten. Anschliessend werden 523 g Bisphenol A-diglycidylether (Epoxidgehalt: 5,26-5,38 val/kg) und nach Abkühlen 375 g Aceton zum Reaktionsprodukt gegeben und homogen vermischt. 500 g dieser Harzlösung werden mit 119 g einer Lösung von Dicyandiamid in Ethylenglykolmonomethylether (10 Gew.-%) und 2,4 g einer Lösung von 2-Methylimidazol in 3-Methoxypropanol (10 Gew.-%) vermischt.
Aus dieser Lösung und Glasgewebe (200 g/m²) werden wie in Beispiel 1 Prepregs hergestellt (Trocknung: 3 min 30 s bei 170 °C), die anschliessend zu einem Laminat verpresst werden (60 min bei 170 °C). Das Laminat weist eine Glasumwandlungstemperatur von 145 °C auf.

### Beispiel 7:

Ein Gemisch aus 467 g Bisphenol A-diglycidylether (Epoxidgehalt: 5,26-5,38 val/kg), 333 g Tetrabrombisphenol A und 200 g Triglycidylisocyanurat wird auf 160 °C erhitzt und ca. 3 h bei dieser Temperatur gehalten. Nach Abkühlen auf ca. 150 °C werden 125 g Methylethylketon zugegeben.
500 g dieser Harzlösung werden mit 143,5 g einer Lösung von Dicyandiamid in Ethylenglykolmonomethylether (10 Gew.-%) und 0,8 g einer Lösung von 2-Methylimidazol in 3-Methoxypropanol (10 Gew.-%) vermischt. Zur Einstellung einer geeigneten Viskosität werden 50 g Ethylenglykolmonomethylether als Verdünnungsmittel zugegeben.
Mit dieser Lösung wird ein Glasgewebe (200 g/m²) imprägniert und 3 min bei 160 °C getrocknet.
Acht Lagen des so erhaltenen Prepregs werden während 60 min bei 170 °C unter einem Druck von 2-4 MPa ausgehärtet.
Das resultierende Laminat hat eine Glasumwandlungstemperatur von 176 °C.

### Beispiel 8:

Ein Gemisch aus 467 g Bisphenol A-diglycidylether (Epoxidgehalt: 5,26-5,38 val/kg) und 200 g Triglycidylisocyanurat wird auf 120 °C erhitzt. Nach Zugabe von 0,013 g 2-Phenylimidazol werden 333 g Tetrabrombisphenol A in drei Portionen hinzugefügt, wobei die zweite und dritte Portion jeweils dann hinzugegeben wird, wenn die vorhergehende Reaktion beendet ist, d.h. wenn der berechnete Epoxidgehalt erreicht ist. Nach beendeter Reaktion (ca. 5 h) werden 125 g Methylethylketon zugegeben.
500 g dieser Harzlösung werden mit 144,4 g einer Lösung von Dicyandiamid in Ethylenglykolmonomethylether (10 Gew.-%) und 0,8 g einer Lösung von 2-Methylimidazol in 3-Methoxypropanol (10 Gew.-%) vermischt. Zur Einstellung einer geeigneten Viskosität werden 77 g Ethylenglykolmonomethylether als Verdünnungsmittel zugegeben.
Mit dieser Lösung wird ein Glasgewebe (200 g/m²) imprägniert und 3 min bei 160 °C getrocknet.
Acht Lagen des so erhaltenen Prepregs werden während 60 min bei 180 °C unter einem Druck von 2-4 MPa ausgehärtet.
Das resultierende Laminat hat eine Glasumwandlungstemperatur von 180 °C.

### Beispiel 9:

Ein Gemisch aus 610 g Bisphenol A-diglycidylether (Epoxidgehalt: 5,26-5,38 val/kg) und 100 g Triglycidylisocyanurat wird auf 120 °C erhitzt. Nach Zugabe von 0,013 g 2-Phenylimidazol werden 290 g Tetrabrombisphenol A in drei Portionen hinzugefügt, wobei die zweite und dritte Portion jeweils dann hinzugegeben wird, wenn die vorhergehende Reaktion beendet ist, d.h. wenn der berechnete Epoxidgehalt erreicht ist. Nach beendeter Reaktion (ca. 5 h) werden 125 g Methylethylketon zugegeben.
700 g dieser Harzlösung werden mit 199,4 g einer Lösung von Dicyandiamid in Ethylenglykolmonomethylether (10 Gew.-%) und 3,92 g einer Lösung von 2-Methylimidazol in 3-Methoxypropanol (10 Gew.-%) vermischt. Zur Einstellung einer geeigneten Viskosität werden 81 g Ethylenglykolmonomethylether als Verdünnungsmittel zugegeben.
Mit dieser Lösung wird ein Glasgewebe (200 g/m²) imprägniert und 3 min bei 170 °C getrocknet.
Acht Lagen des so erhaltenen Prepregs werden während 60 min bei 170 °C unter einem Druck von 2-4 MPa ausgehärtet.
Das resultierende Laminat hat eine Glasumwandlungstemperatur von 155 °C. Brennbarkeit nach UL 94: V-1; totale Brennzeit: 52 s

## Patentansprüche

1. Zusammensetzung enthaltend
(a) eine oder mehrere Polyglycidylverbindungen der Formeln (I), (II) oder (III) 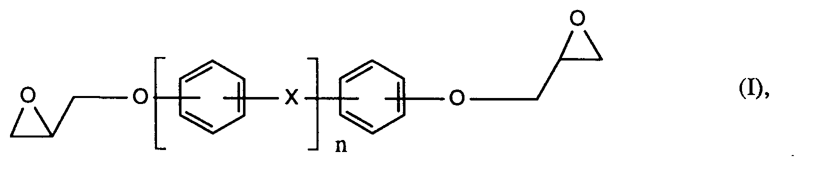 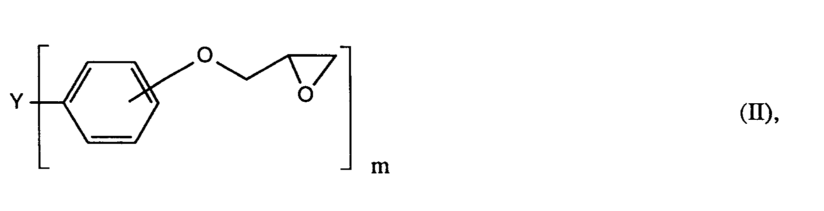 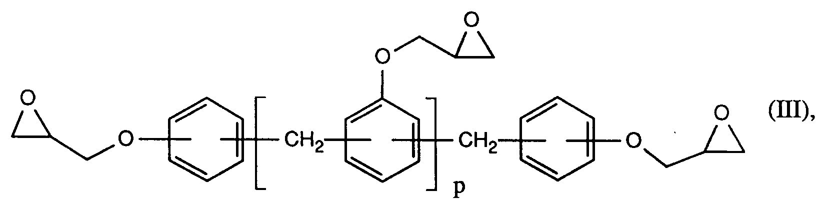 worin X für eine direkte Bindung, -CH₂-, -C(CH₃)₂-, -O-, -CO- oder -SO₂- steht, Y den m-wertigen Rest eines gesättigten C₁-C₃-Kohlenwasserstoffs darstellt, n und p unabhängig voneinander eine ganze Zahl zwischen 1 und 6 bedeuten, m eine ganze Zahl zwischen 2 und 6 ist und worin in den Formeln (I), (II) und (III) die aromatischen Ringe unsubstituiert oder durch eine oder mehrere C₁-C₆-Alkylgruppen oder Halogenatome substituiert sind,
(b) mindestens eine aromatische Di- oder Trihydroxyverbindung und
(c) 1-30 Gew.%, bezogen auf die Gesamtzusammensetzung, Triglycidylisocyanurat.

2. Zusammensetzung nach Anspruch 1 enthaltend als Komponente (a) eine Verbindung der Formel (I), worin X für -C(CH₃)₂- und n für 2 steht.

3. Zusammensetzungen nach Anspruch 1 enthaltend als Komponente (a) Bisphenol A-diglycidylether.

4. Zusammensetzung nach Anspruch 1 enthaltend als Komponente (a) 1,1,2,2-Tetrakis(p-glycidyloxyphenyl)ethan gemäss Formel (II) oder einen Epoxy-Kresolnovolak gemäss Formel (III).

5. Zusammensetzung nach Anspruch 1 enthaltend als Komponente (b) eine Verbindung der Formel (IV) 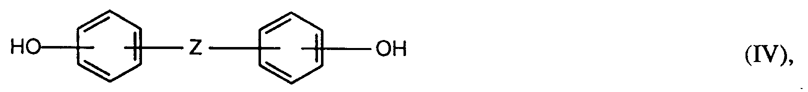 worin Z für eine direkte Bindung, -CH₂-, -C(CH₃)₂-, -O-, -CO- oder -SO₂- steht und worin die aromatischen Ringe unsubstituiert oder durch eine oder mehrere C₁-C₆-Alkylgruppen oder Halogenatome substituiert sind.

6. Zusammensetzung nach Anspruch 5, worin Z für -C(CH₃)₂- steht.

7. Zusammensetzung nach Anspruch 5 enthaltend als Komponente (b) Tetrabrom- bisphenol A.

8. Zusammensetzung nach Anspruch 1 enthaltend die Komponente (a) in einer Menge von 30-90 Gew.%, bezogen auf die Gesamtzusammensetzung.

9. Zusammensetzung nach Anspruch 1 enthaltend die Komponente (b) in einer solchen Menge, dass auf ein Epoxidäquivalent der Komponenten (a)+(c) 0,6-1,2 OH-Gruppenäquivalente entfallen.

10. Zusammensetzung nach Anspruch 1 enthaltend zusätzlich einen Vorverlängerungskatalysator (d).

11. Festes vorverlängertes Epoxidharz erhältlich durch Erhitzen einer Zusammensetzung gemäss Anspruch 1 auf 100-200 °C, bis der Epoxidgehalt des Harzes 2,5-4,0 val/kg beträgt.

12. Verwendung der Epoxidharze gemäss Anspruch 11 zur Herstellung von Prepregs und Laminaten.
